# DEMANDE DE BREVET EUROPEEN

(11) **EP 4 783 769 A1**
(43) Date de publication de la demande: **29.07.2026**
(21) Numéro de dépôt: 26153451.5
(22) Date de dépôt: 22.01.2026
(51) Int. Cl.: H10D 30/01, H10D 30/47, H10D 64/27, H10D 62/85, H10D 64/23

(54) **TRANSISTOR DE PUISSANCE À BASE D'UN MATÉRIAU III-V**

(30) Priorité: 22.01.2025 FR 2500618
(71) Demandeur: Commissariat à l'Energie Atomique et aux Energies Alternatives, 75015 Paris (FR)
(72) Inventeur: BUCKLEY, Julien, 38054 Grenoble Cedex 09 (FR); TORRENGO, Simona, 38054 Grenoble Cedex 09 (FR); PIOTROWICZ, Clémentine, 38054 Grenoble Cedex 09 (FR); MOHAMAD, Blend, 38054 Grenoble Cedex 09 (FR)
(74) Mandataire: Hautier IP

(57) **Abrégé**

L'invention concerne un transistor de puissance 0 à base d'un matériau III-V comprenant :
- un empilement 1 de couches 10, 11, 12, 13, 14 selon une direction verticale (z), ledit empilement comprenant, à partir d'une surface supérieure 100 dudit empilement :
∘ Une première barrière 11 à base d'AlGaN,
∘ Une deuxième barrière 12 à base d'AlGaN ou à base de GaN,
∘ Une troisième barrière 13 à base d'AlGaN, et
∘ Une couche 10 à base dudit matériau III-V,

- un motif de grille 20 comprenant :
∘ Une grille métallique 21,
∘ Un diélectrique de grille 22,

ledit transistor étant tel que le motif de grille traverse totalement la première barrière 11, la deuxième barrière 12 et la troisième barrière 13 et en partie la couche à base dudit matériau III-V 10, selon la direction verticale (z).

## Description

### DOMAINE TECHNIQUE

La présente invention concerne le domaine de la microélectronique. Elle trouve pour application particulièrement avantageuse la réalisation de transistors de puissance à base d'un matériau III-V. Un exemple d'application particulier concerne les transistors GaN à gaz bidimensionnel d'électrons (2DEG).

Plus spécifiquement, des exemples intéressants d'application particuliers concernent les convertisseurs de type « buck » (abaisseur de tension) ou « boost » (élévateur de tension) ainsi que les convertisseurs courant direct / courant alternatif. Les convertisseurs DC-AC, DC-DC et AC-DC sont également des applications pouvant employer l'invention présentée ci-dessous.

### ETAT DE LA TECHNIQUE

Dans le domaine de l'électronique de puissance, un enjeu important concerne le développement de transistors de puissance à base de semiconducteurs « grand gap » tels que le GaN.

Différentes architectures ont été spécifiquement développées pour ces transistors à base de GaN. Les architectures basées sur l'utilisation d'un gaz bidimensionnel d'électrons (2DEG) permettent typiquement de fonctionner avec des tensions de polarisation source-drain élevées. Une tension de seuil positive permet avantageusement de simplifier le circuit de commande du transistor et d'assurer la sécurité du système de conversion en cas de défaillance.

Il est connu du brevet US20170148906A1 un transistor de puissance à base de GaN dans lequel la tranchée de grille MOS traverse une couche de GaN dopé de type p au magnésium (Mg). Cela permet de contrôler la tension de seuil du composant avec la concentration en Mg au niveau des flancs de la grille.

Les inconvénients de cette approche sont :
- La variabilité de procédé liée au profil et la concentration en dopage Mg. L'incertitude sur l'épaisseur et la queue de distribution en dopants est supérieure à 10nm et peut induire de la variabilité dans le contrôle de la tension de seuil,
- L'épaisseur de la couche GaN UID doit être suffisamment importante (environ 100nm ou plus) pour que la queue de distribution liée au dopage Mg n'atteigne pas l'interface AlGaN/GaN et ne dégrade pas la mobilité du 2DEG,
- Le contrôle de la couche de GaN dopé Mg permet d'avoir difficilement une épaisseur inférieure à 100nm,
- Les atomes de Mg limitent la mobilité de la couche d'inversion (<200cm²/V.s) à leur niveau lorsque le composant est en conduction,
- Les trois points précédents contribuent à augmenter la résistance du composant à l'état passant.

Il existe donc un besoin consistant à proposer une architecture de transistor de puissance GaN 2DEG surmontant certains au moins des inconvénients mentionnés ci-dessus.

Il est également connu du brevet US2022352363A1 une structure dans laquelle la grille traverse une back-barrière en AlGaN réalisée par épitaxie. Le pourcentage d'aluminium ainsi que l'épaisseur de cette couche AlGaN permet d'ajuster la tension de seuil (>1V) du composant. Le procédé d'épitaxie est aussi bien maitrisé et implique une faible variabilité d'épaisseur inférieure à 0,5 nm. Le principal inconvénient de cette approche reste une limitation de l'augmentation de la tension de seuil en raison du faible taux de pourcentage d'aluminium de la barrière AlGaN, qui est limité à 8%.

Un objet de la présente invention est de proposer un transistor de puissance à base de GaN présentant une tension de seuil Vth positive et suffisamment élevée, typiquement Vth > 1V et de préférence Vth > 2V.

Les autres objets, caractéristiques et avantages de la présente invention apparaîtront à l'examen de la description suivante et des dessins d'accompagnement. Il est entendu que d'autres avantages peuvent être incorporés.

### RESUME

Pour atteindre cet objectif, selon un mode de réalisation on prévoit un transistor de puissance à base d'un matériau III-V comprenant :
- un empilement de couches selon une direction verticale (z), ledit empilement comprenant, à partir d'une surface supérieure dudit empilement :
   - une première barrière à base d'AlGaN,
   - une deuxième barrière à base d'AlGaN,
   - une troisième barrière à base d'AlGaN, et
   - une couche à base dudit matériau III-V,
- un motif de grille comprenant :
   - une grille métallique,
   - un diélectrique de grille isolant électriquement la grille métallique de l'empilement
- une source et un drain de part et d'autre du motif de grille.

Le transistor est tel que le motif de grille du transistor traverse totalement la première barrière à base d'AlGaN, la deuxième barrière à base d'AlGaN et la troisième barrière à base d'AlGaN et en partie la couche à base dudit matériau III-V, selon la direction verticale (z).

Par ailleurs, la première barrière, la deuxième barrière et la troisième barrière sont configurées pour que, lorsque le transistor de puissance est en fonctionnement, un premier gaz bidimensionnel d'électrons se forme dans la couche à base dudit matériau III-V et un deuxième gaz bidimensionnel d'électrons se forme dans la deuxième barrière.

La présence de l'interface entre la couche à base du matériau III-V et la troisième barrière à base d'AlGaN crée une barrière de potentiel entre le diélectrique de grille (typiquement un oxyde) et l'AlGaN. Cette barrière de potentiel permet de mieux limiter le passage des électrons que dans les transistors de l'art antérieur. En conséquence, la tension de seuil est augmentée par rapport à celle des dispositifs existants.

Il est ainsi proposé un transistor de puissance à base d'un matériau III-V présentant une tension de seuil Vth positive et suffisamment élevée, typiquement Vth > 1V et de préférence Vth > 2V.

### BREVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
La figure 1 représente une vue en coupe du transistor de puissance proposé.
La figure 2 représente des courbes Id-Vg simulées à Vds=0,5V pour une deuxième barrière d'Al_{Y}Ga_{1-Y}N de 30 nm pour un taux d'aluminium Y égal à 0,04, où on varie l'épaisseur de la troisième barrière d'Al_{Z}Ga_{1-Z}N de 0,5 nm à 2 nm avec un taux d'aluminium Z fixé à 1.
La figure 3 représente des courbes Id-Vg simulées à Vds=0,5V pour une deuxième barrière d'Al_{Y}Ga_{1-Y}N de 30 nm pour un taux d'aluminium Y égal à 0,04, où on varie le taux Z d'aluminium de la troisième barrière de 0,5 à 1 pour une épaisseur fixe e13 (t_{z}) de 1nm.
La figure 4 représente des courbes Id-Vg simulées à Vds=0,5V pour une deuxième barrière d'Al_{Y}Ga_{1-Y}N de 30 nm à Y=0,04, 0,15 et 0,001 d'aluminium pour une troisième barrière d'Al_{Z}Ga_{1-Z}N de 1 nm et Z=1. Ces variations sont à comparer avec les précédentes.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier, les épaisseurs relatives des différentes couches illustrées ne sont pas nécessairement représentatives de la réalité.

### DESCRIPTION DÉTAILLÉE

Avant d'entamer une revue détaillée de modes de réalisation de l'invention, sont énoncées ci-après des caractéristiques optionnelles qui peuvent éventuellement être utilisées en association ou alternativement :
Selon un exemple préféré, la première barrière, la deuxième barrière et la troisième barrière présentent respectivement un premier taux d'aluminium X, un deuxième taux d'aluminium Y et un troisième taux d'aluminium Z, le deuxième taux d'aluminium Y étant strictement inférieur au premier taux d'aluminium X et au troisième taux d'aluminium Z.

Selon un exemple, la couche à base de GaN présente une épaisseur e10 comprise entre 50 nm et 200 nm.

Selon un exemple, la troisième barrière à base d'AlGaN présente une épaisseur e13 comprise entre 0,5 nm et 2 nm.

Selon un exemple, la troisième barrière à base d'AlGaN présente un taux d'aluminium, dit troisième taux d'aluminium Z, compris entre 0,5 et 1, à l'exclusion de 1.

Selon un exemple, la deuxième barrière à base d'AlGaN présente une épaisseur e12 comprise entre 25 nm et 50 nm.

Selon un exemple, la deuxième barrière à base d'AlGaN présente un taux d'aluminium, dit deuxième taux d'aluminium Y, compris entre 0,04 et 0,15.

Selon un exemple, la première barrière à base d'AlGaN présente une épaisseur e11 comprise entre 1 nm et 5 nm.

Selon un exemple, la première barrière à base d'AlGaN présente un taux d'aluminium, dit premier taux d'aluminium X, compris entre 0,4 et 1, à l'exclusion de 1.

Selon un exemple, la couche à base dudit matériau III-V est à base de GaN.

Selon un exemple, la couche à base dudit matériau III-V est à base de AlGaN.

Selon un exemple, la couche à base dudit matériau III-V présente un taux d'aluminium, dit quatrième taux d'aluminium, sensiblement égal à 0,04.

Selon un exemple, la grille métallique du motif de grille présente une extrémité au niveau d'un plan basal passant au sein de la troisième barrière à base d'AlGaN.

Selon un exemple, la grille métallique du motif de grille présente une extrémité au niveau d'un plan basal passant au sein de la couche à base dudit matériau III-V.

Selon un exemple, le diélectrique de grille présente une extrémité au niveau d'un plan basal passant au sein de la couche à base dudit matériau III-V.

Selon un exemple, la source du transistor de puissance traverse totalement selon la direction verticale la troisième barrière à base d'AlGaN, la deuxième barrière à base d'AlGaN et la première barrière à base d'AlGaN.

Selon un exemple, le drain du transistor de puissance traverse totalement selon la direction verticale la première barrière à base d'AlGaN.

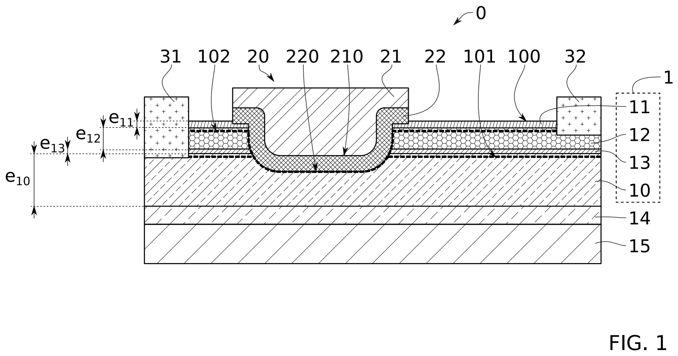

Dans le cadre de la présente invention, et en référence à la figure 1, les architectures de transistors de puissance 0 envisagées sont typiquement à conduction latérale, entre une source 31 et un drain 32, et plus particulièrement basées sur un principe de conduction par gaz bidimensionnel d'électrons (2DEG).

Une telle architecture de transistor 0 inclut la superposition d'au moins deux couches semi-conductrices ayant des bandes interdites différentes qui forment un puits quantique à leur(s) interface(s). Chaque puits quantique est induit par les charges de polarisation spontanée et piézoélectrique en présence. Des électrons sont confinés dans chaque puits quantique pour former au moins un gaz bidimensionnel d'électrons.

Les transistors de type HEMT (acronyme de « High Electron Mobility Transistor », qui signifie transistor à effet de champ à haute mobilité d'électrons), parfois également désignés par le terme de transistor à effet de champ à hétérostructure, sont des exemples de transistors basés sur cette architecture à gaz bidimensionnel d'électrons.

Pour des raisons de tenue en puissance (en particulier haute tension) et en température, le matériau semi-conducteur de ces transistors est choisi de façon à présenter une large bande d'énergie interdite. Parmi les transistors HEMT à large bande d'énergie interdite, les transistors à base de nitrure de gallium GaN sont très prometteurs.

Avec un transistor à conduction latérale, la tension de claquage grille/drain peut aisément être contrôlée par une distance appropriée entre motif de grille 20 et drain 32. Une tension de claquage de l'ordre de 600 V peut ainsi être atteinte pour une distance entre le motif de grille 20 et le drain 32 du transistor 0 de l'ordre de quelques microns (6 à 15 µm par exemple). De plus, de tels transistors permettent de très grandes densités de courant du fait de la très grande mobilité électronique et de la forte densité électronique dans le ou les gaz d'électrons d'interface.

Dans le cadre de la présente invention, le passage du courant est typiquement piloté par une grille métallique 21 polarisée positivement par rapport à la source 31.

Cette grille 20 peut être de type MOS ou MOSFET (acronyme anglais de « Metal Oxide Semiconductor Field Effect Transistor »). Dans ce cas, la grille métallique 21 est isolée électriquement des couches semi-conductrices par un diélectrique de grille 22. D'autres compositions du motif de grille 20 peuvent être envisagées. Une particularité de l'architecture du transistor 0 selon la présente invention est que le motif de grille 20 traverse au moins un, de préférence chaque, puit quantique au niveau duquel est confiné le ou les gaz bidimensionnels d'électrons. La continuité du ou des gaz bidimensionnels d'électrons est ainsi rompue par une tranchée dans laquelle est réalisée la grille MOS du transistor 0.

Généralement, si le motif de grille 20 du transistor 0 est mise à une tension supérieure à une tension seuil Vth, il y a accumulation d'électrons sous le diélectrique de grille 22, connectant ainsi le ou les gaz bidimensionnels d'électrons de part et d'autre de celle-ci ce qui permet de relier la source 31 et le drain 32 de façon à ce que le transistor 0 devienne passant.

Si le motif de grille 20 du transistor 0 est mise à une tension inférieure à la tension seuil Vth, la source 31 et le drain 32 ne sont plus connectés et le transistor 0 est dit bloqué.

Les composants présentant une tension de seuil positive sont dits « à enrichissement » ou en langue anglaise « normally-off ». L'invention s'applique plus particulièrement à des transistors de puissance 2DEG à enrichissement.

Il est précisé que, dans le cadre de la présente invention, les termes « sur », « surmonte », « recouvre », « sous-jacent », en « vis-à-vis » et leurs équivalents ne signifient pas forcément « au contact de ». Ainsi par exemple, le dépôt d'une première couche sur une deuxième couche, ne signifie pas obligatoirement que les deux couches sont directement au contact l'une de l'autre, mais signifie que la première couche recouvre au moins partiellement la deuxième couche en étant soit directement à son contact, soit en étant séparée d'elle par au moins une autre couche ou au moins un autre élément.

Par exemple et de façon connue en soi dans le domaine des transistors de type HEMT à base de GaN, une fine couche en AIN peut être intercalée entre deux couches semi-conductrices en GaN et en AlGaN.

Une couche peut par ailleurs être composée de plusieurs sous-couches d'un même matériau ou de matériaux différents.

On entend par un substrat, un empilement, une couche, « à base » d'un matériau A, un substrat, un empilement, une couche comprenant ce matériau A uniquement ou ce matériau A et éventuellement d'autres matériaux, par exemple des éléments d'alliage et/ou des éléments dopants.

Les gammes de dopage associées aux différents types de dopage indiqués dans la présente demande sont les suivantes :
- dopage p++ ou n++ : supérieur à 1 x 10²⁰cm⁻³
- dopage p+ ou n+ : 1 x 10¹⁸ cm⁻³ à 9 x 10¹⁹ cm⁻³
- dopage p ou n : 1 x 10¹⁷ cm⁻³ à 1 x 10¹⁸ cm⁻³
- dopage intrinsèque ou non intentionnellement dopé : de l'ordre de n.10¹⁵ cm⁻³ ou en-dessous (n étant typiquement compris entre 1 et 9).

Dans la présente demande, il est question des proportions des éléments dans des alliages, notamment dans de l'AlGaN. La notation « AlGaN » sera employée de façon générique. Lorsque l'on souhaitera préciser les proportions des éléments dans cet alliage, on emploiera une notation du type Al_{K}Ga_{1-K}N, où K est le taux d'aluminium dans l'alliage. Le taux d'aluminium est compris entre 0 et 1, sans unité (0 et 1 étant de préférence exclus dans la présente application). Le taux d'aluminium peut également être désigné par la fraction molaire en aluminium. Il est entendu que l'indice « K » peut être modifié pour distinguer les taux d'aluminium d'une couche à l'autre (voir plus avant les notations Al_{X}Ga_{1-X}N, Al_{Y}Ga_{1-Y}N, Al_{Z}Ga_{1-Z}N et Al_{W}Ga_{1-W}N). Il est à noter également qu'au lieu d'exprimer le taux d'aluminium par une valeur comprise entre 0 et 1, sans unité, il est possible de l'exprimer par un pourcentage compris entre 0 et 100, noté également taux de pourcentage d'aluminium. Ainsi, un taux de 0,1 est équivalent à une concentration de 10%, ou encore équivalent à un taux de pourcentage de 10%.

Un repère de préférence orthonormé, comprenant les axes x, y, z est représenté sur les figures annexées. Lorsqu'un seul repère est représenté sur une même planche de figures, ce repère s'applique à toutes les figures de cette planche.

Dans la présente demande de brevet, l'épaisseur d'une couche est prise selon une direction normale au plan d'extension principal de la couche. Ainsi, une couche présente typiquement une épaisseur selon z. Les termes relatifs « sur », « surmonte », « sous », « sous-jacent » se réfèrent à des positions prises selon la direction z.

Les termes « vertical », « verticalement » se réfèrent à une direction selon z. Les termes « horizontal », « horizontalement » se réfèrent à une direction dans le plan xy.

Un élément situé « à l'aplomb » ou « au droit d' » un autre élément signifie que ces deux éléments sont situés tous deux sur une même ligne perpendiculaire à un plan dans lequel s'étend principalement une face inférieure ou supérieure d'un substrat, c'est-à-dire sur une même ligne orientée verticalement sur les figures.

On entend par un paramètre « sensiblement égal/supérieur/inférieur à » une valeur donnée que ce paramètre est égal/supérieur/inférieur à la valeur donnée, à plus ou moins 20 %, voire 10 %, près de cette valeur. On entend par un paramètre « sensiblement compris entre » deux valeurs données que ce paramètre est au minimum égal à la plus petite valeur donnée, à plus ou moins 20 %, voire 10 %, près de cette valeur, et au maximum égal à la plus grande valeur donnée, à plus ou moins 20 %, voire 10 %, près de cette valeur.

Un exemple de transistor 0 selon la présente invention est illustré à la figure 1. L'architecture générale du transistor 0 comprend une source 31 et un drain 32 formés de part et d'autre d'un motif de grille 20. Le motif de grille 20 s'étend en partie au travers d'un empilement 1 de couches 10, 11, 12, 13, 14 formé sur un substrat 15.

Le substrat 15 peut être un substrat à base de Silicium (111). Alternativement, le substrat 15 peut être à base de saphir ou de SiC. Des substrats connus de GaN sur saphir ou de GaN sur silicium peuvent typiquement être utilisés.

L'empilement 1 peut comprendre une pluralité de couches à base de matériaux III-V épitaxiées sur le substrat 15. L'empilement 1 comprend ainsi typiquement, en partant du substrat 15 et selon la direction z :
- Une ou plusieurs couches 14 dites tampon. Ces couches 14 ont pour objectif d'améliorer la qualité cristalline des couches supérieures. Elles peuvent par exemple accorder les différences de paramètres de maille entre les matériaux III-V utilisés et le substrat 25, et/ou encaisser la relaxation plastique induite par les différentes sources de contraintes mécaniques, et/ou limiter l'apparition ou la transmission des défauts cristallins.
- Une couche 10 à base d'un matériau III-V, tel que le GaN ou l'AlGaN, de préférence non intentionnellement dopée. Lorsque la couche est à base d'AlGaN, elle comprend de préférence un taux d'aluminium, dit quatrième taux d'aluminium et noté W, par exemple sensiblement égale à 0,04. Le taux d'aluminium de la couche 10 correspond à la valeur de W dans la composition avec fractions molaires de forme Al_{W}Ga_{1-W}N. La couche 10 à base d'un matériau III-V peut présenter une épaisseur e10, par exemple comprise entre 50 nm et 200 nm. On considère ci-dessous de façon non limitative que la couche 10 est à base de GaN ;
- Une troisième barrière 13 à base d'AlGaN. La troisième barrière 13 à base d'AlGaN peut présenter une épaisseur e13 comprise entre 0,5 nm et 2 nm. La troisième barrière 13 présente un taux d'aluminium, dit troisième taux d'aluminium Z ou troisième fraction molaire Z, correspondant à la valeur de Z dans la formule Al_{Z}Ga_{1-Z}N. Elle peut par exemple présenter un taux d'aluminium de 0,5 à 1, la valeur Z=1 étant exclue. De préférence, Z est compris entre 0,5 et 0,99. ;
- Une deuxième barrière 12 à base d'AlGaN. La deuxième barrière 12 à base d'AlGaN peut présenter une épaisseur e12 comprise entre 25 nm et 50 nm. De préférence, la valeur de 50 nm est exclue de cette plage. Par exemple, l'épaisseur e12 peut être comprise entre 25 nm et 40 nm. La deuxième barrière 12 présente un taux d'aluminium, dit deuxième taux d'aluminium Y ou deuxième fraction molaire Y, correspondant à la valeur de Y dans la formule Al_{Y}Ga_{1-Y}N. Elle peut présenter un taux d'aluminium de 0 à 0,15, la valeur de Y=0 étant exclue. De préférence, Y est compris entre 0,04 et 0,15. ;
- Une première barrière 11 à base d'AlGaN. La première barrière 11 à base d'AlGaN peut présenter une épaisseur e11 (tₓ), par exemple comprise entre 1 nm et 5 nm. La première barrière 11 présente un taux d'aluminium, dit premier taux d'aluminium X ou première fraction molaire X, correspondant à la valeur de X dans la formule Al_{X}Ga_{1-X}N. Elle peut présenter un taux d'aluminium de 0,4 à 1.

Les différentes couches épitaxiées, en particulier les première, deuxième et troisième barrières 11, 12, 13 et la couche 10 à base de GaN, peuvent être très précisément contrôlées en épaisseur. Une variabilité inférieure à 0,5 nm en épaisseur est typiquement obtenue pour ces couches épitaxiées. Cela permet in fine de contrôler précisément les distances séparant les différentes couches et les effets électrostatiques visés.

Dans cet empilement 1, un premier gaz bidimensionnel d'électrons 101 se forme dans la couche 10 à base de GaN et un deuxième gaz bidimensionnel d'électrons 102 se forme sous la première barrière 11 à base d'AlGaN. Le premier gaz bidimensionnel d'électrons 101 est typiquement confiné à l'interface entre la troisième barrière 13 à base d'AlGaN et la couche 10 à base de GaN. Le deuxième gaz bidimensionnel d'électrons 102 est typiquement confiné à l'interface entre la première barrière 11 à base d'AlGaN et la deuxième barrière 12 à base d'AlGaN.

Plus spécifiquement, et toujours en référence à la figure 1, le motif de grille 20 traverse la deuxième barrière 12 en Al_{Y}Ga_{1-Y}N (par exemple de 25 nm à 50 nm d'épaisseur, et par exemple avec une fraction molaire en aluminium de 0 à 0,15), puis la troisième barrière 13 d'Al_{Z}Ga_{1-Z}N réalisée aussi par épitaxie et avec un taux d'aluminium typiquement beaucoup plus élevée, par exemple de l'ordre de 0,5 à 1, et typiquement avec une très faible épaisseur de 0,5 nm à 2 nm. L'interface GaN/Al_{Z}Ga_{1-Z}N (10/13) a pour effet de moduler le passage des électrons en raison de la barrière de potentiel entre l'AlGaN et l'oxyde jouant typiquement le rôle de diélectrique de grille. La deuxième couche barrière 12 d'Al_{Y}Ga_{1-Y}N a pour rôle de bloquer le passage des électrons par effet tunnel par la troisième barrière 13 d'Al_{Z}Ga_{1-Z}N vers le drain 32. Une épaisseur minimale ici de 25 nm pour la deuxième barrière 12 en Al_{Y}Ga_{1-Y}N a ainsi été définie d'après des simulations TCAD.

Un taux d'aluminium Z de la troisième couche barrière 13 élevé (compris entre 0,5 et 1 par exemple) permet de conserver un taux d'aluminium Y beaucoup plus faible dans la deuxième couche barrière, de l'ordre de 0,04 à 0,15. Cela permet d'augmenter le niveau de courant dans le deuxième gaz bidimensionnel d'électrons 102 et de garder une excellente mobilité des électrons, conduisant à des performances améliorées du transistor.

Pour que les gaz bidimensionnels d'électrons 101, 102 apparaissent lors du fonctionnement du transistor, on prévoit avantageusement que les taux d'aluminium dans la première barrière 11, la deuxième barrière 12 et la troisième barrière 13 sont différents les uns des autres. Selon un avantage, lorsque la couche 10 est à base d'AlGaN, son taux d'aluminium est strictement inférieur à celui de la troisième barrière 13. Avantageusement, on prévoit que le taux d'aluminium Y dans la deuxième barrière 12 est strictement inférieur aux taux d'aluminium X et Z dans la première barrière 11 et dans la troisième barrière 13. Cela provoque naturellement l'apparition du premier gaz bidimensionnel 101 et du deuxième gaz bidimensionnel 102. Le taux d'aluminium X dans la première barrière 11 n'est pas nécessairement égal au taux d'aluminium Z dans la troisième barrière 13. Les trois taux X, Y, Z peuvent ainsi être tous différents les uns des autres. X et Z peuvent éventuellement être égaux.

Un autre paramètre de dimensionnement important est l'épaisseur de chacune des barrières 11, 12, 13 et de la couche 10 à base de GaN. Typiquement, une fois les taux d'aluminium W, X, Y, Z fixés, les différentes épaisseurs e10, e11, e12, e13 sont dimensionnées en fonction. Notamment, le dimensionnement des épaisseurs se fait pour limiter voire éviter tout problème de dislocation de l'empilement.

Les avantages de cette architecture 1 par rapport aux documents de l'état de l'art présentés en introduction sont :
- Un seuil modulable potentiellement supérieur à 3V défini par la jonction GaN/Al_{Z}Ga_{1-Z}N (10/13) et ajustable avec l'épaisseur et le taux d'aluminium dans la couche 13 d'Al_{Z}Ga_{1-Z}N ;
- Un contact de source (S) 31 pouvant optionnellement être relié au deuxième gaz bidimensionnel d'électrons 102 (2-DEG2) et au premier gaz bidimensionnel d'électrons 101 (2-DEG1) pour réduire la résistance d'accès du côté source ;
- Une profondeur du motif de grille 20 réduite (> e12 (t_{y}) + e13 (t_{z})).

La structure 1 a été simulée par TCAD sous l'environnement Sentaurus, Synopsys. Le motif de grille 20 traverse les deuxième et troisième barrières 12 et 13 consécutives d'Al_{Y}Ga_{1-Y}N et d'Al_{Z}Ga_{1-Z}N respectivement d'épaisseur préférentielle dans la gamme 20 à 50 nm avec un taux d'Al dans la gamme 0,04 à 0,15, et d'épaisseur préférentielle dans la gamme 0,5 à 2 nm avec un taux d'Al dans la gamme 0,5 à 1.

Le contact de source (S) 31 est défini comme traversant intégralement les deuxième et troisième barrières 12 et 13 d'Al_{Y}Ga_{1-Y}N et d'Al_{Z}Ga_{1-Z}N. Ainsi le passage des électrons se fait par les deux gaz bidimensionnels d'électrons 101 et 102 de la source 31 vers le motif de grille 20. Coté du drain 32, le contact reste uniquement connecté au deuxième gaz bidimensionnel d'électrons 102 (2-DEG2), la gravure traverse partiellement la deuxième couche barrière 12 d'Al_{Y}Ga_{1-Y}N.

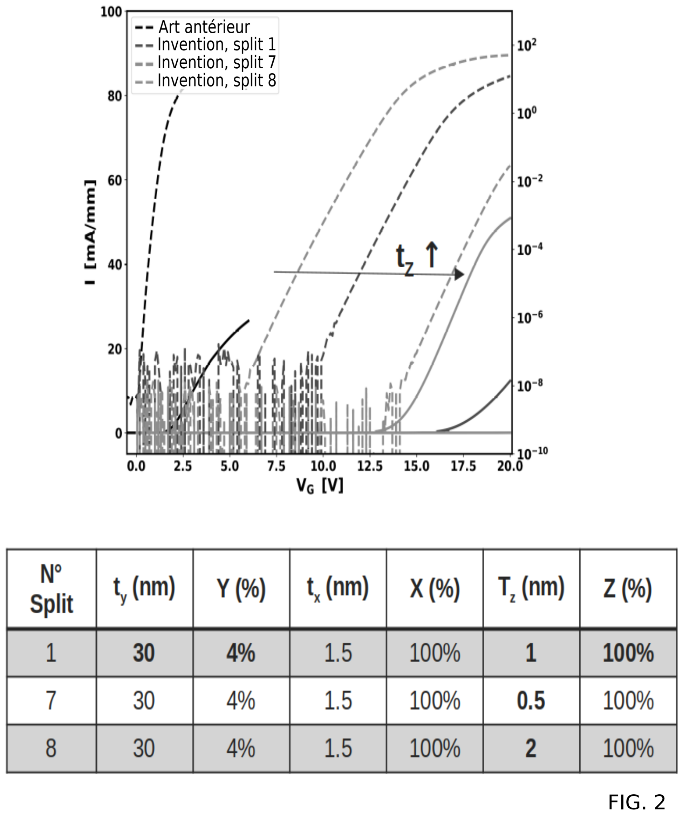

On notera que dans les figures 2 à 4 les premier, deuxième, et troisième taux d'aluminium, X, Y, Z sont exprimés en pourcentage. En d'autres termes différentes valeurs des taux de pourcentage d'aluminium X, Y, Z respectivement des première, deuxième et troisième barrières 11, 12, 13 sont indiquées sur les figures 2 à 4.

La figure 2 montre la simulation de la caractéristique IdVg en fonction de l'épaisseur e13 de la troisième couche barrière 13 d'Al_{Z}Ga_{1-Z}N et l'impact sur la tension de seuil Vth.

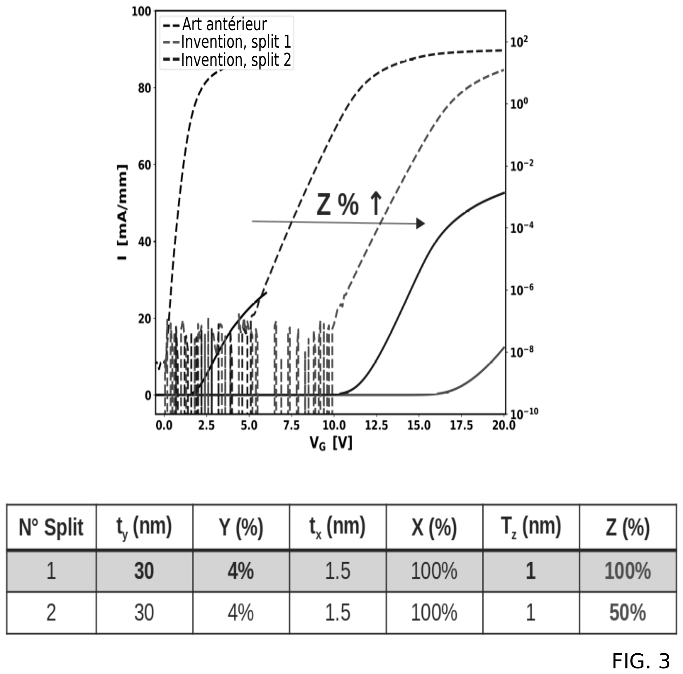

La figure 3 montre l'impact de la concentration en aluminium de la troisième couche barrière 13 d'Al_{Z}Ga_{1-Z}N sur la tension de seuil Vth. Au premier ordre, l'épaisseur e13 de la troisième barrière 13 d'Al_{Z}Ga_{1-Z}N ainsi que le pourcentage de la barrière d'aluminium de cette troisième couche barrière 13 d'Al_{Z}Ga_{1-Z}N permet une forte modulation de la tension de seuil V_{TH} largement supérieure à 3V.

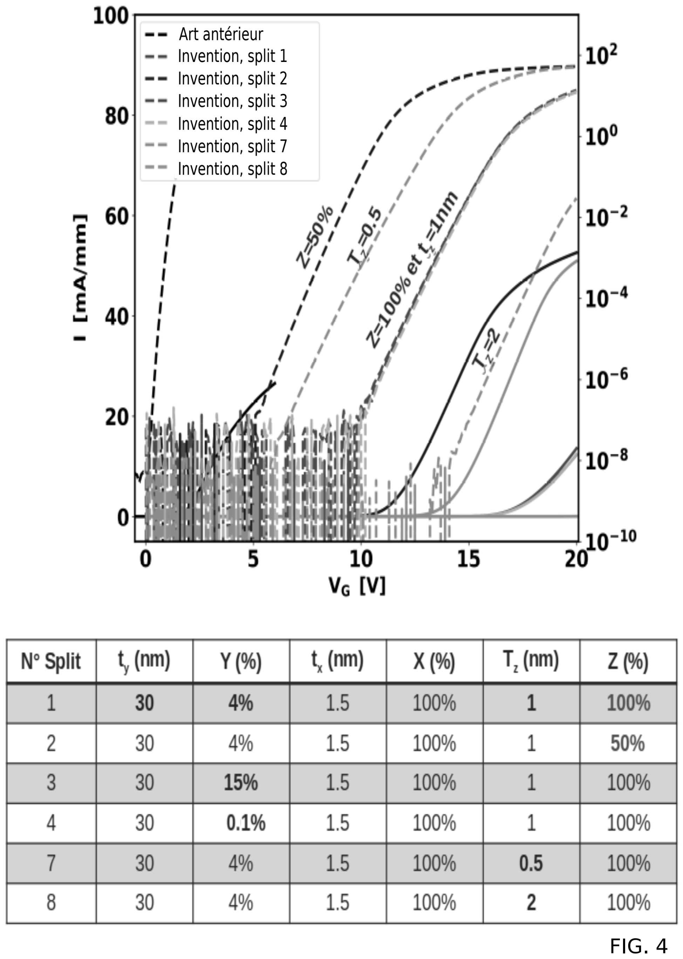

La figure 4 montre la simulation de l'effet du taux d'aluminium de la deuxième barrière 12 d'Al_{Y}Ga_{1-Y}N sur la caractéristique IdVg et la tension de seuil Vth. Cette figure 4 permet ainsi de comparer, l'ensemble des variations étudiées et on note que plus le pourcentage d'aluminium est important dans la troisième barrière 13 d'Al_{Z}Ga_{1-Z}N et plus la tension de seuil Vth est augmentée, de même avec l'épaisseur e13 (t_{z}). Cette figure 4 montre aussi la possibilité de garder un faible pourcentage d'aluminium, voire de considérer du GaN, dans le canal de la deuxième couche barrière 12, ce qui permet d'augmenter le niveau de courant et de garder une excellente mobilité des électrons.

Comme déjà introduit ci-dessus, il est proposé une variante dans laquelle on remplace le matériau GaN de la couche 10 à base d'un matériau III-V par une couche à base AlGaN à un faible taux d'Aluminium par exemple sensiblement égale à 0,04, ce qui présente les avantages d'augmenter la tension de seuil Vth supérieure à 2V et qui en raison du champ de claquage supérieur de cette couche 10 devrait améliorer les propriétés de l'ensemble de la structure en blocage. En complément, il est possible de doper en carbone la couche 10 à base d'un matériau III-V pour améliorer la tenue en tensions ou encore d'ajouter une fine couche d'AIN tout en gardant une connexion de source 31 via les deux gaz bidimensionnels d'électrons 101 et 102 ce qui permettrait de moduler comme précédemment la tension de seuil Vth.

L'invention n'est pas limitée aux modes de réalisations précédemment décrits et s'étend à tous les modes de réalisation couverts par l'invention.

## Revendications

1. Transistor de puissance (0) à base d'un matériau III-V comprenant :
• un empilement (1) de couches (10, 11, 12, 13, 14) selon une direction verticale (z), ledit empilement (1) comprenant, à partir d'une surface supérieure (100) dudit empilement :
- une première barrière (11) à base d'AlGaN,
- une deuxième barrière (12) à base d'AlGaN,
- une troisième barrière (13) à base d'AlGaN, et
- une couche à base dudit matériau III-V (10),
• un motif de grille (20) comprenant :
- une grille métallique (21),
- un diélectrique de grille (22) isolant électriquement la grille métallique (21) de l'empilement (1),
• une source (31) et un drain (32) de part et d'autre du motif de grille (20), ledit transistor étant **caractérisé en ce que** le motif de grille (20) du transistor traverse totalement la première barrière (11) à base d'AlGaN, la deuxième barrière (12) à base d'AlGaN et la troisième barrière (13) à base d'AlGaN et en partie la couche à base dudit matériau III-V (10), selon la direction verticale (z),
et **en ce que** la première barrière (11), la deuxième barrière (12) et la troisième barrière (13) sont configurées pour que, lorsque le transistor de puissance (0) est en fonctionnement, un premier gaz bidimensionnel d'électrons (101) se forme dans la couche à base dudit matériau III-V (10) et un deuxième gaz bidimensionnel d'électrons (102) se forme dans la deuxième barrière (12).

2. Transistor de puissance (0) selon la revendication précédente, dans lequel la première barrière (11), la deuxième barrière (12) et la troisième barrière (13) présentent respectivement un premier taux d'aluminium (X), un deuxième taux d'aluminium (Y) et un troisième taux d'aluminium (Z), le deuxième taux d'aluminium (Y) étant strictement inférieur au premier taux d'aluminium (X) et au troisième taux d'aluminium (Z).

3. Transistor de puissance (0) selon l'une quelconque des revendications précédentes, dans lequel la couche (10) à base dudit matériau III-V présente une épaisseur e10 comprise entre 50 nm et 200 nm.

4. Transistor de puissance (0) selon l'une quelconque des revendications précédentes, dans lequel la troisième barrière (13) à base d'AlGaN présente une épaisseur e13 comprise entre 0,5 nm et 2 nm.

5. Transistor de puissance (0) selon l'une quelconque des revendications précédentes, dans lequel la troisième barrière (13) à base d'AlGaN présente un taux d'aluminium, dit troisième taux d'aluminium (Z), compris entre 0,5 et 1, à l'exclusion de 1.

6. Transistor de puissance (0) selon l'une quelconque des revendications précédentes, dans lequel la deuxième barrière (12) à base d'AlGaN présente une épaisseur e12 comprise entre 25 nm et 50 nm.

7. Transistor de puissance (0) selon l'une quelconque des revendications précédentes, dans lequel la deuxième barrière (12) à base d'AlGaN présente un taux d'aluminium, dit deuxième taux d'aluminium (Y), compris entre 0,04 et 0,15.

8. Transistor de puissance (0) selon l'une quelconque des revendications précédentes, dans lequel la première barrière (11) à base d'AlGaN présente une épaisseur e11 comprise entre 1 nm et 5 nm.

9. Transistor de puissance (0) selon l'une quelconque des revendications précédentes, dans lequel la première barrière (11) à base d'AlGaN présente un taux d'aluminium, dit premier taux d'aluminium (X), compris entre 0,4 et 1, à l'exclusion de 1.

10. Transistor de puissance (0) selon l'une quelconque des revendications précédentes, dans lequel la couche à base dudit matériau III-V (10) est à base de AlGaN et présente un taux d'aluminium, dit quatrième taux d'aluminium (W), sensiblement égal à 0,04.

11. Transistor de puissance (0) selon l'une quelconque des revendications précédentes, dans lequel la grille métallique (21) du motif de grille (20) présente une extrémité (210) au niveau d'un plan basal (xy) passant au sein de la troisième barrière (13) à base d'AlGaN.

12. Transistor de puissance (0) selon l'une quelconque des revendications précédentes, dans lequel la grille métallique (21) du motif de grille (20) présente une extrémité (210) au niveau d'un plan basal (xy) passant au sein de la couche (10) à base dudit matériau III-V.

13. Transistor de puissance (0) selon l'une quelconque des revendications précédentes, dans lequel le diélectrique de grille (22) présente une extrémité (220) au niveau d'un plan basal (xy) passant au sein de la couche (10) à base dudit matériau III-V.

14. Transistor de puissance (0) selon l'une quelconque des revendications précédentes, dans lequel ladite source (31) traverse totalement selon la direction verticale (z) la troisième barrière (13) à base d'AlGaN, la deuxième barrière (12) à base d'AlGaN et la première barrière (11) à base d'AlGaN.

15. Transistor de puissance (0) selon l'une quelconque des revendications précédentes, dans lequel le drain (32) traverse totalement selon la direction verticale (z) la première barrière (11) à base d'AlGaN.
